(19) **Europäisches Patentamt / European Patent Office / Office européen des brevets**

(11) **EP 1 079 519 B1**

(12) **EUROPEAN PATENT SPECIFICATION**

(45) Date of publication and mention of the grant of the patent:
**09.07.2008 Bulletin 2008/28**

(51) Int Cl.:
***H03F 3/345*** (2006.01)     ***G05F 3/26*** (2006.01)

(21) Application number: **00202920.5**

(22) Date of filing: **21.08.2000**

(54) **A power rising electronic device**

Elektronisches Leistungsanstiegsgerät

Dispositif électronique d'élévation à une puissance

(84) Designated Contracting States:
**DE FR GB IT**

(30) Priority: **25.08.1999 US 382244**

(43) Date of publication of application:
**28.02.2001 Bulletin 2001/09**

(73) Proprietors:
- **STMicroelectronics S.r.l.**
  **20041 Agrate Brianza (Milano) (IT)**
- **Hewlett-Packard Company**
  **(a Delaware Corporation)**
  **Palo Alto, CA 94304 (US)**

(72) Inventors:
- **Maggi, Riccardo**
  **I-27012 Certosa Di Pavia (Pavia) (IT)**
- **Ghozeil, Adam**
  **Corvallis,**
  **Oregon 97330 (US)**

(74) Representative: **Pezzoli, Ennio et al**
Jacobacci & Perani S.p.A.
**Via Senato, 8**
**20121 Milano (IT)**

(56) References cited:
| | |
|---|---|
| **GB-A- 1 465 499** | **US-A- 5 602 509** |
| **US-A- 5 712 594** | **US-A- 5 831 327** |

EP 1 079 519 B1

**Description**

The present invention relates to a power rising electronic device.

Power rising electronic devices are commonly used in various applications such as, for example, in analog calculating systems. A power rising electronic device can provide an output current which is a function of a power of an input current with a relative whole-number (either positive or negative) exponent; in particular, in the case of a square law electronic device, the output current is proportional to the square of the input current.

Power rising electronic devices are formed with the use of one of more multiplier circuits. A disadvantage of this solution is that it requires a fairly complex structure; if the electronic device is produced in integrated form in a chip of semiconductor material, this leads to the occupation of a considerable amount of space. Moreover, multiplier circuits require very precise tuning of the components used to prevent drift of the output current, for example, due to temperature variations.

An example for a circuit which is capable of producing a square law characteristic is given in US 581327.

A different known solution consists of the use of one or more MOS field effect transistors in which the current at the drain terminal is proportional to the square of the voltage between the source terminal and the gate terminal. However, this relationship is influenced to a fairly marked extent by variations in temperature and in the drain terminal voltage, so that the electronic device is not very precise.

The object of the present invention is to overcome the above-mentioned drawbacks. In order to achieve this object, a power rising electronic device as described in the first claim is proposed.

In short, there is provided a power rising electronic device for receiving an input current and for supplying an output current which is a linear function of a power of the input current with a relative whole-number exponent, comprising a number of diodes equal to the absolute value of the relative whole-number exponent, connected in series with one another so as to produce, from the input current, an input voltage which is a logarithmic function of a power of the input current with an exponent equal ,to said absolute value, an output junction element, and means for applying a voltage which is a linear function of the input voltage to the output junction element so as to produce a current which is an exponential function of the voltage applied, the output current being derived from the current in the output junction element.

A corresponding power rising method is also proposed.

Further characteristics and the advantages of the power rising electronic device according to the present invention will become clear from the following description of a preferred embodiment thereof, provided by way of non-limiting example, with reference to the appended drawings, in which:

Figure 1a is a basic circuit diagram of the electronic device,

Figure 1b shows a different embodiment of the electronic device,

Figure 2 shows the curve of the output current as a function of the input current at various temperatures, for the electronic device of Figure 1a.

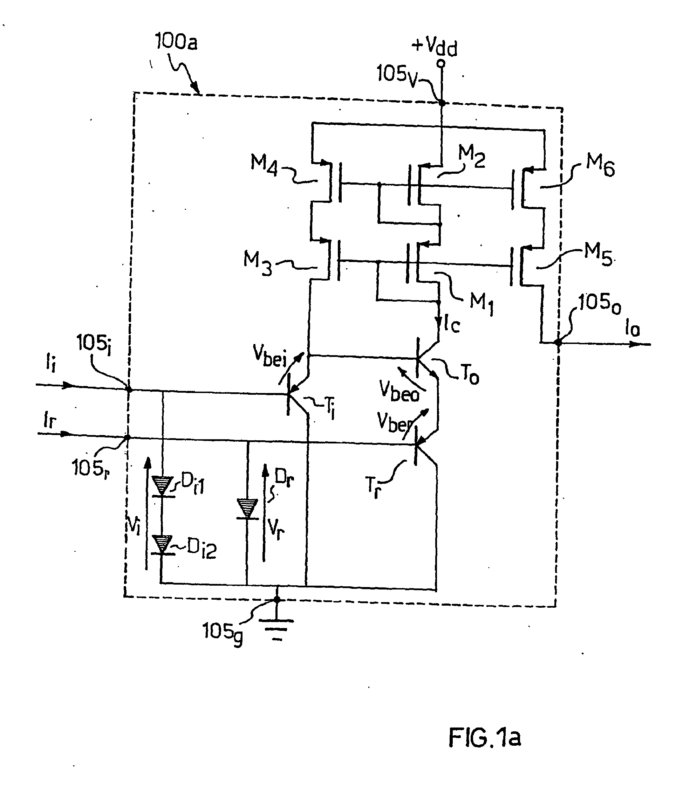

With reference in particular to Figure 1a, this shows a square law electronic device 100a, produced in integrated form in a chip of semiconductor material with the use of a bipolar-CMOS (or BICMOS) technique. The electronic device 100a has two supply terminals 105g and 105v. The supply terminal 105g is connected to a reference terminal (or ground); the supply terminal 105v is connected to the positive terminal of a direct-current supply +Vdd (for example, a 5V supply), the negative terminal of which is connected to the ground terminal. The electronic device 100a also has an input terminal 105i which receives an input current Ii, an output terminal 105o which supplies an output current Io, and a reference terminal 105r which receives a reference current Ir of predetermined value.

Two diodes Di1 and Di2 are connected in series between the input terminal 105i and the supply terminal 105g. In particular, the anode terminal of the diode Di1 is connected to the input terminal 105i; the cathode terminal of the diode Di1 is connected to the anode terminal of the diode Di2, the cathode terminal of which is connected to the supply terminal 105g. A further diode Dr has its anode terminal connected to the reference terminal 105r and its cathode terminal connected to the supply terminal 105g.

The electronic device 100a also includes a pnp bipolar transistor Ti having its base terminal connected to the input terminal 105i and its collector terminal connected to the supply terminal 105g. A further pnp bipolar transistor Tr has its base terminal connected to the reference terminal 105r and its collector terminal connected to the supply terminal 105g. In the electronic device 100a, there is also an npn bipolar transistor To having its base terminal connected to the emitter terminal of the transistor Ti and its emitter terminal connected to the emitter terminal of the transistor Tr.

A dual current-mirror with a cascode structure is formed by six p-channel MOS transistors M1, M2, M3, M4, M5, and M6; the current-mirror M1-M6 has an input branch M1, M2 connected to the collector terminal of the transistor To, a first output branch M3, M4, connected to the emitter terminal of the transistor Ti, and a second output branch M5, M6 connected to the output terminal 105o.

In particular, the drain terminal of the transistor M1 is connected to the collector terminal of the transistor To; the source terminal of the transistor M1 is connected to the drain terminal of the transistor M2, the source terminal of which is connected to the supply terminal 105v. The gate terminals of the transistors M1 and M2 are short-circuited to their respective drain terminals. The drain terminal of the transistor M3 is connected to the emitter terminal of the transistor Ti; the source terminal of the transistor M3 is connected to the drain terminal of the transistor M4, the source terminal of which is connected to the supply terminal 105v. Similarly, the drain terminal of the transistor M5 is connected to the output terminal 105o; the source terminal of the transistor M5 is connected to the drain terminal of the transistor M6, the source terminal of which is connected to the supply terminal 105v. The gate terminals of the transistors M3, M5 and of the transistors M4, M6 are connected to the gate terminals of the transistors M1 and M2, respectively.

If the base current of the transistor Ti is considered negligible, the current through the diodes Di1 and Di2 is equal to the input current Ii. From the equation which defines the relation between the voltage and the current in a generic pn junction:

$$Ii = Isi \cdot (e^{\frac{V1}{Vt}} - 1) \text{ and } Ii = Isi \cdot (e^{\frac{V2}{Vt}} - 1)$$

in which V1 and V2 are the voltages at the terminals of the diodes Di1 and Di2, respectively, Isi is the inverse saturation current of the diodes Di1 and Di2, and Vt is the thermal voltage. If the unit relative to the exponential is ignored, the voltage V1 and the voltage V2 are equal to:

$$V1 = Vt \cdot \ln\left(\frac{Ii}{Isi}\right) \text{ and } V2 = Vt \cdot \ln\left(\frac{Ii}{Isi}\right)$$

The voltage Vi at the terminals of the series of diodes Di1 and Di2 is thus:

$$Vi = Vt \cdot \ln\left(\frac{Ii}{Isi}\right) + Vt \cdot \ln\left(\frac{Ii}{Isi}\right) = 2 \cdot Vt \cdot \ln\left(\frac{Ii}{Isi}\right) = Vt \cdot \ln\left(\frac{Ii^2}{Isi^2}\right)$$

Similarly, if the base current of the transistor Tr is ignored and the inverse saturation current of the diode Dr is indicated Isr, the voltage Vr at the terminals of the diode Dr is:

$$Vr = Vt \cdot \ln\left(\frac{Ir}{Isr}\right)$$

Now, the base-emitter voltages of the transistors Ti and Tr will be indicated Vbei and Vber, respectively. If the voltages Vbei and Vber are considered substantially equal to one another, the base-emitter voltage Vbeo of the transistor To is equal to:

$$Vbeo = Vt \cdot \ln\left(\frac{Ii^2}{Isi^2}\right) + Vbei - Vt \cdot \ln\left(\frac{Ir}{Isr}\right) - Vber = Vt \cdot \ln\left(\frac{Ii^2}{Isi^2} \cdot \frac{Isr}{Ir}\right)$$

With similar considerations applied to the transistor To, if the base and collector currents are indicated Ib and Ic, respectively, if the static current gain is indicated hfe, and if the inverse saturation current of the base-emitter junction is indicated Iso:

$$Ic = hfe \cdot Ib = hfe \cdot Iso \cdot (e^{\frac{Vbeo}{Vt}} - 1) \cong hfe \cdot Iso \cdot e^{\frac{Vbeo}{Vt}} = hfe \cdot Iso \cdot e^{\frac{Vt}{Vt}\ln\left(\frac{Ii^2 \cdot Isr}{Isi^2 \cdot Ir}\right)} =$$

$$= hfe \cdot Iso \cdot \left(\frac{Ii^2 \cdot Isr}{Isi^2 \cdot Ir}\right) = \left(hfe \cdot \frac{Isr \cdot Iso}{Isi^2 \cdot Ir}\right) \cdot Ii^2$$

The current Ic is mirrored by the structure M1, M2, M5, M6 towards the output terminal 105o (with the branch M3, M4 operating as an active load of the transistor Ti) so that:

$$Io = Ic = \left(hfe \cdot \frac{Isr \cdot Iso}{Isi^2 \cdot Ir}\right) \cdot Ii^2$$

In particular, upon the assumption that Isi = Isr = Iso and hfe = 1:

$$Io = \frac{Ii^2}{Ir}$$

The output current Io is thus proportional to the square of the input current Ii.

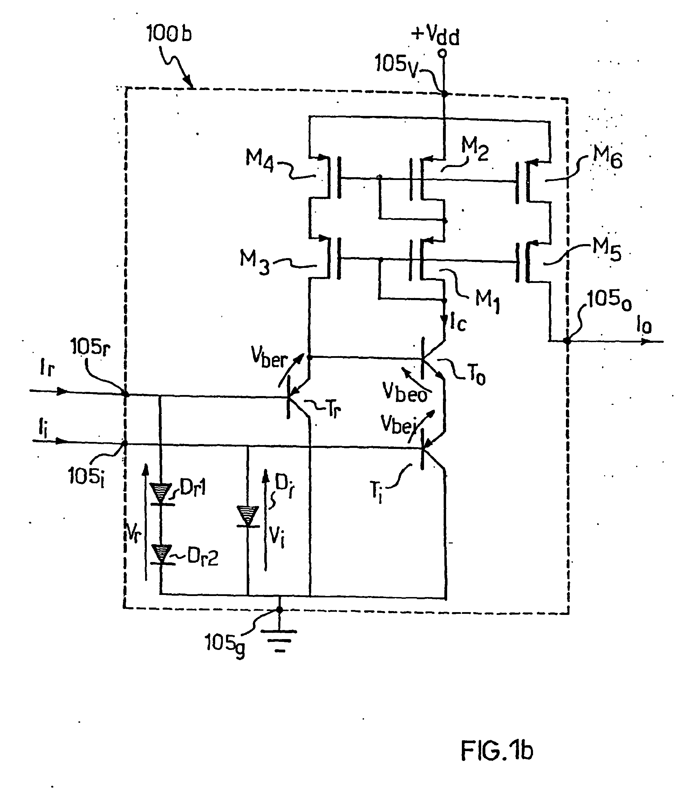

Alternatively, as shown in Figure 1b (elements corresponding to those shown in the previous drawing are identified by the same reference numerals or symbols and an explanation thereof is omitted for simplicity of description), an electronic device 100b with a hyperbolic law is provided.

In this case, a single diode Di is connected between the input terminal 105i and the supply terminal 105g and two diodes Dr1 and Dr2 are connected in series between the reference terminal 105r and the supply terminal 105g. The transistor To has its base terminal connected to the emitter terminal of the transistor Tr and its emitter terminal connected to the emitter terminal of the transistor Ti.

By similar considerations to those given above:

$$Vi = Vt \cdot \ln\left(\frac{Ii}{Isi}\right) \text{ and } Vr = Vt \cdot \ln\left(\frac{Ir^2}{Isr^2}\right)$$

from which:

$$Vbeo = Vt \cdot \ln\left(\frac{Ir^2}{Isr^2}\right) + Vber - Vt \cdot \ln\left(\frac{Ii}{Isi}\right) - Vbei = Vt \cdot \ln\left(\frac{Ir^2}{Isr^2} \cdot \frac{Isi}{Ii}\right)$$

The output current Io is thus equal to:

$$Io = Ic = hfe \cdot Iso \cdot e^{\frac{Vt}{Vt}\ln\left(\frac{Ir^2 \cdot Isi}{Isr^2 \cdot Ii}\right)} = hfe \cdot Iso \cdot \left(\frac{Ir^2 \cdot Isi}{Isr^2 \cdot Ii}\right) = \left(hfe \cdot \frac{Ir^2 \cdot Isi \cdot Iso}{Isr^2}\right) \cdot Ii^{-1}$$

In particular, upon the assumption that Isi = Isr = Iso and hfe = 1:

$$Io = Ir^2 \cdot Ii^{-1}$$

The output current Io is thus a hyperbolic function of the input current Ii (that is, their product is constant).

Similar considerations apply if the electronic device is produced by a different technique or is not in integrated form, if equivalent circuit arrangements are used, for example, with the output transistor To replaced by a different junction element, if the various diodes are formed by bipolar transistors, if the transistors Ti, Tr are of npn type and the transistor To is of pnp type, if the load of the transistor Ti is constituted by a resistor, etc.

More generally, the arrangement according to the present invention provides a power rising electronic device in which the output current is a linear function of a power of the input current with a relative whole-number (that is, positive or negative) exponent. One or more diodes, the number of diodes being equal to the absolute value N of the exponent, are connected in series with one another to produce, from the input current, an input voltage which is a logarithmic function of an Nth power of the input current. The electronic device includes an output junction element to which a voltage which is a linear function of the input voltage is applied so as to produce a current which is an exponential function of the voltage applied, and from which the output current is obtained.

The arrangement of the present invention is extremely simple. The electronic device is particularly compact and occupies a limited amount of space on the chip of semiconductor material (when it is produced in integrated form).

The electronic device according to the present invention is very accurate and stable since it is affected in very limited manner by temperature variations.

Moreover, the output current is independent of the supply voltage so that the electronic device has very high supply-voltage noise rejection.

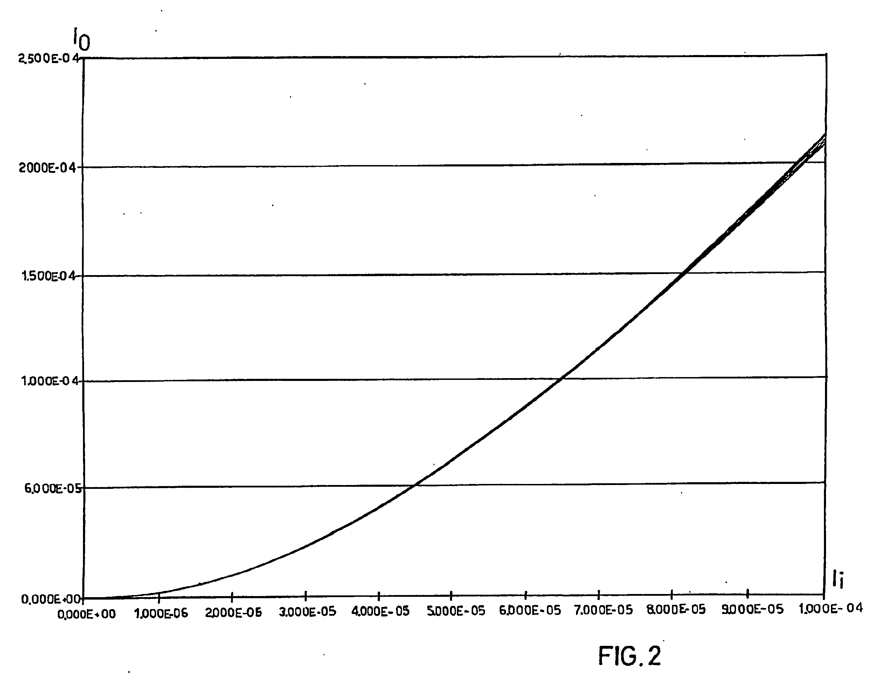

In the particular embodiment of the present invention shown in Figure 1a (similar considerations apply to the electronic device of Figure 1b), the diode Dr and the reference current Ir produce a voltage Vbeo which is directly proportional, in accordance with the thermal voltage Vt, to the logarithmic term having the square of the input current Ii as its argument. The term Vt, which is greatly dependent on temperature, thus disappears from the formula which defines the output current Io. Figure 2 shows, by way of example, the curve of the output current Io as a function of the input current Ii, with the reference current Ir set at 40μA. In particular, several curves of the output current Io at various temperatures between 20°C and 90°C are shown. As can be seen, the output current Io is substantially independent of the temperature. Moreover, the output current Io is directly proportional to the square of the input current Ii (without any linear component).

These elements also ensure that the voltage Vbeo has a value such as to permit correct biasing of the transistor To. In particular, in the embodiment shown in Figure 1a (in which the voltage Vbeo is equal to the difference between the voltage Vi and the voltage Vr), the number of diodes (Dr) connected to the reference terminal 105r is, in general, equal to the number of diodes (Di1, Di2) connected to the input terminal 105i minus one, whereas in the embodiment shown in Figure 1b (in which the voltage Vbeo is equal to the difference between the voltage Vr and the voltage Vi), the number of diodes (Dr1, Dr1) connected to the reference terminal 105r is equal to the number of diodes (Di) connected to the input terminal 105i plus one.

The transistors Ti and Tr are used to decouple the diodes Di1, Di2 and Dr, respectively, from the transistor To, so that the input current Ii and the reference current Ir flow entirely through the corresponding diodes Di1, Di2 and Dr. The transistors Ti, Tr also operate as voltage translators for biasing the transistor To.

The current-mirror M1-M6 decouples the transistor To from a load (not shown in the drawing) connected to the output terminal 105o; the output current Io is thus substantially independent of an output voltage at the terminals of the load. Moreover, the cascode structure of the current-mirror M1-M6 ensures great accuracy of the mirror factor.

Similar considerations apply if a different number of diodes is connected to the input terminal and to the reference terminal, if other equivalent means are provided for supplying a reference voltage, if the transistors Ti and Tr are replaced by other decoupling elements, if the current-mirror does not have a cascode structure, etc. The electronic device of the present invention may, in any case, also be formed with other means for applying a voltage which is a linear function of the voltage Vi between the base terminal and the emitter terminal of the transistor To, or with other means for deriving the output current Io from the current Ic (or even a simple connection between the collector terminal of the transistor To and the output terminal 105o).

Naturally, in order to satisfy contingent and specific requirements, an expert in the art may apply to the above-described power rising electronic device many modifications and variations all of which, however, are included within the scope of protection of the invention as defined by the following claims.

**Claims**

1. A power rising electronic device (100a; 100b) for receiving an input current (Ii) and for supplying an output current (Io) which is a linear function of a power of the input current (Ii) with a relative whole-number exponent, **characterized in that** it includes a number of diodes (Di1, Di2; Di) equal to the absolute value of the relative whole-number exponent, connected in series with one another so as to produce, from the input current (Ii), an input voltage (Vi) which is a logarithmic function of a power of the input current (Ii) with an exponent equal to said absolute value, an output junction element (To), and means (105r, Dr, Ti, Tr; 105r, Dr1, Dr2, Ti, Tr) for applying a voltage (Vbeo) which is a linear function of the input voltage (Vi) to the output junction element (To) so as to produce a current (Ic) which is an exponential function of the voltage (Vbeo) applied, the output current (Io) being derived from the current in the output junction element (Ic).

2. An electronic device (100a; 100b) according to Claim 1, in which the output junction element is an output bipolar transistor (To), the voltage applied being a base-emitter voltage (Vbeo) and the current in the output junction element being a collector current (Ic).

3. An electronic device (100a; 100b) according to Claim 2, further comprising reference means (105r, Dr; 105r, Dr1, Dr2) for supplying a reference voltage (Vr), the base-emitter voltage (Vbeo) being equal to the difference between the input voltage (Vi) and the reference voltage (Vr), or *vice versa.*

4. An electronic device (100a; 100b) according to Claim 3, further comprising an input terminal (105i) for receiving the input current (Ii) and a supply terminal (105g), the diodes (Di1, Di2; Di) being connected between the input terminal (105i) and the supply terminal (105g), and in which the reference means (105r, Dr; 105r, Dr1, Dr2) include a reference terminal (105r) for receiving a reference current (Ir) and a number of further diodes (Dr; Dr1, Dr2) equal to said absolute value minus one if the base-emitter voltage (Vbeo) is equal to the difference between the input voltage (Vi) and the reference voltage (Vr), or equal to said absolute value plus one if the base-emitter voltage (Vbeo) is equal to the difference between the reference voltage (Vr) and the input voltage (Vi), in which the further diodes (Dr; Dr1, Dr2) are connected in series between the reference terminal (105r) and the supply terminal (105g) for obtaining the reference voltage (Vr) from the reference current (Ir), the reference voltage (Vr) being a logarithmic function of a power of the reference current (Ir) with an exponent equal to the number of further diodes (Dr; Dr1, Dr2).

5. An electronic device (100a; 100b) according to Claim 4, further comprising a first decoupling element (Ti) connected between the input terminal (105i) and a first of the base terminal and the emitter terminal of the output transistor (To), and a second decoupling element (Tr) connected between the reference terminal (105r) and a second different of the base terminal and the emitter terminal of the output transistor (To).

6. An electronic device (100a; 100b) according to Claim 5, in which the first decoupling element and the second decoupling element include, respectively, a first bipolar transistor (Ti) and a second bipolar transistor (Tr) having a polarity (pnp) opposite to a polarity (npn) of the output transistor (To), the first transistor (Ti) having an emitter terminal connected to the first terminal of the output transistor (To), a base terminal connected to the input terminal (105i) and a collector terminal connected to the supply terminal (105g), and the second transistor (Tr) having an emitter terminal connected to the second terminal of the output transistor (To), a base terminal connected to the reference terminal (105r), and a collector terminal connected to the supply terminal (105g).

7. An electronic device (100a; 100b) according to any one of Claims 1 to 6, further comprising an output terminal (105o) for supplying the output current (Io) and a current-mirror (M1-M6) connected between a collector terminal of the output transistor (To) and the output terminal (105o), the output current (Io) being equal to the collector current (Ic).

8. An electronic device (100a; 100b) according to Claim 7, in which the current-mirror (M1-M6) has a cascode structure.

9. An electronic device (100a; 100b) according to Claim 7 or Claim 8, in which the current-mirror (M1-M6) is a dual current-mirror with an input branch (M1, M2) connected between the collector terminal of the output transistor (To) and a further supply terminal (105v), a first output branch (M3, M4) connected between the base terminal of the output transistor (To) and the further supply terminal (105v), and a second output branch (M5, M6) connected between the output terminal (105o) and the further supply terminal (105v).

10. A power rising method comprising the steps of:

receiving an input current (Ii), and
supplying an output current (Io) which is a linear function of a power of the input current (Ii) with a relative whole-number exponent,
**characterized by** the steps of
obtaining from the input current (Ii) an input voltage (Vi) which is a logarithmic function of a power of the input current (Ii) with an exponent equal to the absolute value of the relative whole-number exponent, by means of a number of diodes (Di1, Di2; Di) equal to said absolute value connected in series with one another, applying a voltage (Vbeo) which is a linear function of the input voltage (Vi) to an output junction element (To) so as to obtain a current (Ic) which is an exponential function of the voltage (Vbeo) applied, and deriving the output current (Io) from the current in the output junction element (Ic).

**Patentansprüche**

1. Eine elektronische Potensierungsvorrichtung (100a; 100b) zum Empfangen eines Eingangsstroms (Ii) und zum Zuführen eines Ausgangsstroms (Io), der eine lineare Funktion einer Potenz des Eingangsstroms (Ii) mit einem relativen ganzzahligen Exponenten ist,
   **gekennzeichnet dadurch, dass**
   sie eine Anzahl von Dioden (Di1, Di2; Di) gleich dem Absolutwert des relativen ganzzahligen Exponenten umfasst, die in Reihe miteinander geschaltet sind, um aus dem Eingangsstrom (Ii) eine Eingangsspannung (Vi) zu erzeugen, die eine logarithmische Funktion einer Potenz des Eingangsstroms (Ii) mit einem Exponenten gleich dem Absolutwert ist, ein Ausgangsverbindungselement (To) und eine Einrichtung (105r, Dr, Ti, Tr; 105r, Dr1, Dr2, Ti, Tr) zum Anlegen einer Spannung (Vbeo), die eine lineare Funktion der Eingangsspannung (vi) ist, an das Ausgangsverbindungselement (To), um einen Strom (Ic) zu erzeugen, der eine Exponentialfunktion der angelegten Spannung (Vbeo) ist, umfasst, wobei der Ausgangsstrom (Io) von dem Strom in dem Ausgangsverbindungselement (Ic) abgeleitet ist.

2. Eine elektronische Vorrichtung (100a; 100b) gemäß Anspruch 1, bei der das Ausgangsverbindungselement ein bipolarer Ausgangstransistor (To) ist, wobei die angelegte Spannung eine Basis-Emitter-Spannung (Vbeo) ist und der Strom in dem Ausgangsverbindungselement ein Kollektorstrom (Ic) ist.

3. Eine elektronische Vorrichtung (100a; 100b) gemäß Anspruch 2, die ferner eine Referenzeinrichtung (105r, Dr; 105r, Dr1, Dr2) zum Zuführen einer Referenzspannung (Vr) aufweist, wobei die Basis-Emitter-Spannung (Vbeo) gleich der Differenz zwischen der Eingangsspannung (Vi) und der Referenzspannung (Vr) oder umgekehrt ist.

4. Eine elektronische Vorrichtung (100a ; 100b) gemäß Anspruch 3, die ferner einen Eingangsanschluss (105i) zum Empfangen des Eingangsstroms (Ii) und einen Versorgungsanschluss (105g) aufweist, wobei die Dioden (Di1, Di2; Di) zwischen den Eingangsanschluss (105i) und den Versorgungsanschluss (105g) geschaltet sind, und bei der die Referenzeinrichtung (105r, Dr; 105r, Dr1, Dr2) einen Referenzanschluss (105r) zum Empfangen eines Referenzstroms (Ir) und eine Anzahl weiterer Dioden (Dr; Dr1, Dr2) gleich dem Absolutwert minus Eins, wenn die Basis-Emitter-Spannung (Vbeo) gleich der Differenz zwischen der Eingangsspannung (Vi) und der Referenzspannung (Vr) ist, oder gleich dem Absolutwert plus Eins, wenn die Basis-Emitter-Spannung (Vbeo) gleich der Differenz zwischen der Referenzspannung (Vr) und der Eingangsspannung (Vi) ist, umfasst, bei der die weiteren Dioden (Dr; Dr1, Dr2) zum Erhalten der Referenzspannung (Vr) aus dem Referenzstrom (Ir) zwischen den Referenzanschluss (105r) und den Versorgungsanschluss (105g) in Reihe geschaltet sind, wobei die Referenzspannung (Vr) eine logarithmische Funktion einer Potenz des Referenzstroms (Ir) mit einem Exponenten gleich der Anzahl der weiteren Dioden (Dr; Dr1, Dr2) ist.

5. Eine elektronische Vorrichtung (100a; 100b) gemäß Anspruch 4, die ferner ein erstes Entkopplungselement (Ti) aufweist, das zwischen den Eingangsanschluss (105i) und einen ersten des Basisanschlusses und des Emitteranschlusses des Ausgangstransistors (To) geschaltet ist, und ein zweites Entkopplungselement (Tr) aufweist, das zwischen den Referenzanschluss (105r) und einen zweiten anderen des Basisanschlusses und des Emitteranschlusses des Ausgangstransistors (To) geschaltet ist.

6. Eine elektronische Vorrichtung (100a; 100b) gemäß Anspruch 5, bei der das erste Entkopplungselement und das zweite Entkopplungselement einen ersten bipolaren Transistor (Ti) und einen zweiten bipolaren Transistor (Tr) mit einer Polarität (pnp), die zu einer Polarität (npn) des Ausgangstransistors (To) entgegengesetzt ist, umfassen, wobei bei dem ersten Transistor (Ti) ein Emitteranschluss mit dem ersten Anschluss des Ausgangstransistors (To) verbunden ist, ein Basisanschluss mit dem Eingangsanschluss (105i) verbunden ist und ein Kollektoranschluss mit dem versorgungsanschluss (105g) verbunden ist, und wobei bei dem zweiten Transistor (Tr) ein Emitteranschluss mit dem zweiten Anschluss des Ausgangstransistors (To) verbunden ist, ein Basisanschluss mit dem Referenzanschluss (105r) verbunden ist und ein Kollektoranschluss mit dem Versorgungsanschluss (105g) verbunden ist.

7. Eine elektronische Vorrichtung (100a; 100b) gemäß einem der Ansprüche 1 bis 6, die ferner einen Ausgangsanschluss (105o) zum Zuführen des Ausgangsstroms (Io) und einen Stromspiegel (M1-M6), der zwischen einen Kollektoranschluss des Ausgangstransistors (To) und den Ausgangsanschluss (105o) geschaltet ist, aufweist, wobei der Ausgangsstrom (Io) gleich dem Kollektorstrom (Ic) ist.

**8.** Eine elektronische Vorrichtung (100a; 100b) gemäß Anspruch 7, bei der der Stromspiegel (M1-M6) eine Kaskodenstruktur aufweist.

**9.** Eine elektronische Vorrichtung (100a; 100b) gemäß Anspruch 7 oder Anspruch 8, bei der der Stromspiegel (M1-M6) ein Dualstromspiegel ist, mit einem Eingangszweig (M1, M2), der zwischen den Kollektoranschluss des Ausgangstransistors (To) und einen weiteren Versorgungsanschluss (105v) geschaltet ist, einem ersten Ausgangszweig (M3, M4), der zwischen den Basisanschluss des Ausgangstransistors (To) und den weiteren Versorgungsanschluss (105v) geschaltet ist, und einem zweiten Ausgangszweig (M5, M6), der zwischen den Ausgangsanschluss (105o) und den weiteren Versorgungsanschluss (105v) geschaltet ist.

**10.** Ein Potenzierungsverfahren, das die folgenden Schritte aufweist:

Empfangen eines Eingangsstroms (Ii), und
Zuführen eines Ausgangsstroms (Io), der eine lineare Funktion einer Potenz des Eingangsstroms (Ii) mit einem relativen ganzzahligen Exponenten ist,
**gekennzeichnet durch** folgende Schritte:

Erhalten, aus dem Eingangsstroms (Ii), einer Eingangsspannung (Vi), die eine logarithmische Funktion einer Potenz des Eingangsstroms (Ii) mit einem Exponenten gleich dem Absolutwert des relativen ganzzahligen Exponenten ist, mittels einer Anzahl von Dioden (Di1, Di2; Di) gleich dem Absolutwert, die in Reihe miteinander geschaltet sind,
Anlegen einer Spannung (Vbeo), die eine lineare Funktion der Eingangsspannung (Vi) ist, an ein Ausgangsverbindungselement (To), um einen Strom (Ic) zu erhalten, der eine Exponentialfunktion der angelegten Spannung (Vbeo) ist, und
Ableiten des Ausgangsstroms (Io) aus dem Strom in dem Ausgangsverbindungselement (Ic).

## Revendications

**1.** Dispositif électronique d'élévation de puissance (100a; 100b) destiné à recevoir un courant d'entrée (Ii) et à alimenter un courant de sortie (Io) qui est une fonction linéaire d'une puissance du courant d'entrée (Ii) avec un exposant en nombre entier relatif, **caractérisé en ce qu'**il inclut un certain nombre de diodes (Di1, Di2 ; Di) égal à la valeur absolue de l'exposant en nombre entier relatif, qui sont connectées en série les unes avec les autres afin de produire, à partir du courant d'entrée (Ii), une tension d'entrée (Vi) qui est une fonction logarithmique d'une puissance du courant d'entrée (Ii) avec un exposant égal à ladite valeur absolue, un élément à jonction de sortie (To), et des moyens (105r, Dr, Ti, Tr ; 105r, Dr1, Dr2, Ti, Tr) permettant d'appliquer une tension (Vbeo) qui est une fonction linéaire de la tension d'entrée (Vi) sur l'élément à jonction de sortie (To), de façon à produire un courant (Ic) qui est une fonction exponentielle de la tension (Vbeo) appliquée, le courant de sortie (Io) étant dérivé du courant dans l'élément à jonction de sortie (Ic).

**2.** Dispositif électronique (100a ; 100b) selon la revendication 1, dans lequel l'élément à jonction de sortie est un transistor bipolaire de sortie (To), la tension appliquée étant une tension base-émetteur (Vbeo) et le courant dans l'élément à jonction de sortie étant un courant de collecteur (Ic).

**3.** Dispositif électronique (100a; 100b) selon la revendication 2, comprenant en outre des moyens de référence (105r, Dr ; 105r, Dr1, Dr2) destinés à alimenter une tension de référence (Vr), la tension base-émetteur (Vbeo) étant égale à la différence entre la tension d'entrée (Vi) et la tension de référence (Vr), ou *vice versa.*

**4.** Dispositif électronique (100a; 100b) selon la revendication 3, comprenant en outre une borne d'entrée (105i) destinée à recevoir le courant d'entrée (Ii) et une borne d'alimentation (105g), les diodes (Di1 ; Di2 ; Di) étant connectées entre la borne d'entrée (105i) et la borne d'alimentation (105g), et dans lequel les moyens de référence (105r, Dr ; 105r, Dr1, Dr2) incluent une borne de référence (105r) destinée à recevoir un courant de référence (Ir) et un certain nombre d'autres diodes (Dr ; Dr1, Dr2) égal à ladite valeur absolue moins un, si la tension base-émetteur (Vbeo) est égale à la différence entre la tension d'entrée (Vi) et la tension de référence (Vr) ou égale à ladite valeur absolue plus un, si la tension base-émetteur (Vbeo) est égale à la différence entre la tension de référence (Vr) et la tension d'entrée (Vi), dans lequel les autres diodes (Dr; Dr1, Dr2) sont connectées en série entre la borne de référence (105r) et la borne d'alimentation (105g), afin d'obtenir la tension de référence (Vr) à partir du courant de référence (Ir), la tension de référence (Vr) étant une fonction logarithmique d'une puissance de courant de référence (Ir) avec un exposant égal au nombre des autres diodes (Dr ; Dr1 ; Dr2).

5. Dispositif électronique (100a ; 100b) selon la revendication 4, comprenant en outre un premier élément de découplage (Ti) connecté entre la borne d'entrée (105i) et une première de la borne de base et de la borne d'émetteur du transistor de sortie (To), et un second élément de découplage (Tr) connecté entre la borne de référence (105r) et une seconde, différente, de la borne de base et de la borne d'émetteur du transistor de sortie (To).

6. Dispositif électronique (100a ; 100b) selon la revendication 5, dans lequel le premier élément de découplage et le second élément de découplage incluent, respectivement, un premier transistor bipolaire (Ti) et un second transistor bipolaire (Tr) ayant une polarité (pnp) opposée à une polarité (npn) du transistor de sortie (To), le premier transistor (Ti) ayant une borne d'émetteur connectée à la première borne du transistor de sortie (To), une borne de base connectée à la borne d'entrée (105i) et une borne de collecteur connectée à la borne d'alimentation (105g), et le second transistor (Tr) ayant une borne d'émetteur connectée à la seconde borne du transistor de sortie (To), une borne de base connectée à la borne de référence (105r), et une borne de collecteur connectée à la borne d'alimentation (105g).

7. Dispositif électronique (100a; 100b) selon l'une quelconque des revendications 1 à 6, comprenant en outre une borne de sortie (105o) destinée à alimenter le courant de sortie (Io) et un miroir de courant (M1 à M6) connecté entre une borne de collecteur du transistor de sortie (To) et la borne de sortie (105o), le courant de sortie (Io) étant égal au courant de collecteur (Ic).

8. Dispositif électronique (100a ; 100b) selon la revendication 7, dans lequel le miroir de courant (M1-M6) a une structure cascode.

9. Dispositif électronique (100a ; 100b) selon la revendication 7 ou la revendication 8 dans lequel le miroir de courant (M1-M6) est un miroir de courant double avec une dérivation d'entrée (M1, M2) connectée entre la borne de collecteur du transistor de sortie (To) et une autre borne d'alimentation (105v), une première dérivation de sortie (M3, M4) connectée entre la borne de base du transistor de sortie (To) et l'autre borne d'alimentation (105v), et une seconde dérivation de sortie (M5, M6) connectée entre la borne de sortie (105o) et l'autre borne d'alimentation (105v).

10. Méthode d'élévation de puissance comprenant les étapes consistant à :

recevoir un courant d'entrée (Ii) et
fournir un courant de sortie (Io) qui est une fonction linéaire d'une puissance du courant d'entrée (Ii) avec un exposant en nombre entier relatif,
**caractérisée par** les étapes consistant à
obtenir du courant d'entrée (Ii) une tension d'entrée (Vi) qui est une fonction logarithmique d'une puissance du courant d'entrée (Ii) avec un exposant égal à la valeur absolue de l'exposant du nombre entier relatif, au moyen d'un certain nombre de diodes (Di1, Di2 ; Di) égal à ladite valeur absolue, connectées en série les unes avec les autres,
appliquer une tension (Vbeo) qui est une fonction linéaire de la tension d'entrée (Vi) à un élément à jonction de sortie (To), de façon à obtenir un courant (Ic) qui est une fonction exponentielle de la tension (Vbeo) appliquée, et
dériver le courant de sortie (Io) du courant dans l'élément à jonction de sortie (Ic).

FIG.1a

FIG.1b

FIG.2

**EP 1 079 519 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 581327 A